Europäisches Patentamt

European Patent Office

Office européen des brevets

(11) Veröffentlichungsnummer: **0 388 903**
**A2**

## EUROPÄISCHE PATENTANMELDUNG

(21) Anmeldenummer: 90105269.6

(51) Int. Cl.5: **H01L 41/12**

(22) Anmeldetag: 20.03.90

(30) Priorität: 20.03.89 BG 87720/89

(43) Veröffentlichungstag der Anmeldung:
26.09.90 Patentblatt 90/39

(84) Benannte Vertragsstaaten:
CH DE FR GB LI SE

(71) Anmelder: **EKOTECH**
**"Marin Baev" Strasse no. 71**
**BG-3230 Stadt Knezha(BG)**

(72) Erfinder: **Hristemov, Dimiter Mihajlov,**
**Dipl.-Ing.**
**P. Lilov-Strasse 24**
**1574 Sofia(BG)**
Erfinder: **Zanov, Dimtscho Dimitrov, Dipl.-Ing.**
**Komplex Mladost-1, Block 49**
**Sofia(BG)**
Erfinder: **Bonev, Peter Bonev, Dipl.-Ing.**
**Obelja-2, Block 253-2**
**Sofia(BG)**
Erfinder: **Bischev, Juri Ivanov, Dipl.-Ing.**
**Iv. Bojilov-Strasse, Block B**
**Sofia 1517(BG)**

(74) Vertreter: **Ebbinghaus, Dieter et al**
**Patentanwälte v. Füner, Ebbinghaus, Finck**
**Mariahilfplatz 2 & 3**
**D-8000 München 90(DE)**

(54) **Striktiomagnetischer Wandler zum Erfassen und Messen von Drehmomenten und ihrer dynamischen Änderungen.**

(57) Der striktiomagnetische Wandler hat eine erhöhte Empfindlichkeit und ist zum Einsatz in der Meßtechnik bestimmt. Er enthält eine Welle 1, die wenigstens an ihrer Oberfläche einen ferromagnetischen Werkstoff mit striktiomagnetischen Eigenschaften aufweist, und wenigstens zwei konzentrisch zur Welle 1 angeordnete Wicklungen 2, 7. Die äußerste Wicklung ist eine Erregerwicklung 3, die rechtwinklig zu den übrigen Wicklungen auf einen hohlen zylindrischen Magnetkern 4 gewickelt ist, der die Welle 1 und die anderen Wicklungen 2, 7, 10, 11 koaxial umgibt.

Fig. 1

## Striktiomagnetischer Wandler zum Erfassen und Messen von Drehmomenten und ihrer dynamischen Änderungen

Die Erfindung bezieht sich auf einen striktiomagnetischen Wandler zum Erfassen und/oder Messen von Drehmomenten und ihrer dynamischen Änderungen, mit einer Welle, wobei wenigstens die Oberfläche der Welle aus ferromagnetischem Werkstoff mit striktiomagnetischen Eigenschaften besteht, und mit wenigstens zwei konzentrisch zur Welle angeordneten Wicklungen. Ein solcher Wandler ist aus J. I. Rybaltschenko: Magnitouprugie datschiki krutjaschtego momenta, Moskau, 1981, S. 15, bekannt.

Ein Nachteil des bekannten striktiomagnetischen Wandlers zum Erfassen und Messen von Drehmomenten und ihrer dynamischen Änderungen liegt in seiner niedrigen Empfindlichkeit. Im besten Fall stimmt nämlich die Richtung der Magnetflüsse in den Umformbereichen nur teilweise mit den Richtungen der Haupt-Scher-, Zug- und Druckspannungen überein, die infolge der Verdrehung zylindrischer Wellen entstehen.

Der Erfindung liegt die Aufgabe zugrunde, einen striktiomagnetischen Wandler zum Erfassen und Messen von Drehmomenten und ihrem dynamischen Änderungen mit erhöhter Empfindlichkeit zu schaffen.

Diese Aufgabe wird erfindungsgemäß durch einen striktiomagnetischen Wandler zum Erfassen und Messen von Drehmomenten und ihrer dynamischen Änderungen gelöst, dessen Welle wenigstens an ihrer Oberfläche mit einem ferromagnetischen Werkstoff mit striktiomagnetischen Eigenschaften versehen ist und der wenigstens zwei konzentrisch zur Welle angeordnete Wicklungen aufweist. Die äußerste Wicklung dient als Erregerwicklung. Sie ist in Bezug auf die übrigen Wicklungen rechtwinklig auf einen hohlen zylindrischen Magnetkern gewickelt, der die Welle und die übrigen Wicklungen koaxial umgibt.

Weil bei dem erfindungsgemäßen Wandler die Magnetflüsse mit den mechanischen Zug- und Druckspannungen zusammenfallen und die gesamte Wellenzone ausgenutzt wird, hat der erfindungsgemäße striktiomagnetische Wandler eine erhöhte Empfindlichkeit. Er hat außerdem eine erhöhte Genauigkeit und ist einfach und billig herzustellen.

Ausführungsbeispiele des erfindungsgemäßen striktiomagnetischen Wandlers zum Erfassen und Messen von Drehmomenten und ihrer dynamischen Änderungen werden anhand der Zeichnung erläutert. Es zeigen in schematischer Darstellung:

Fig. 1 einen Wandler vom Drossel-Differentialtyp mit alternativer Funktion,

Fig. 2 einen Wandler vom Drossel-Differentialtyp,

Fig. 3 einen Wandler vom Transformator-Differentialtyp mit alternativer Funktion,

Fig. 4 einen Wandler vom Transformator-Differentialtyp,

Fig. 5 eine abgewandelte Ausführungsform eines Wandlers vom Transformator-Differentialtyp und

Fig. 6 einen abgewandelte Ausführungsform eines Wandlers vom Transformator-Differentialtyp.

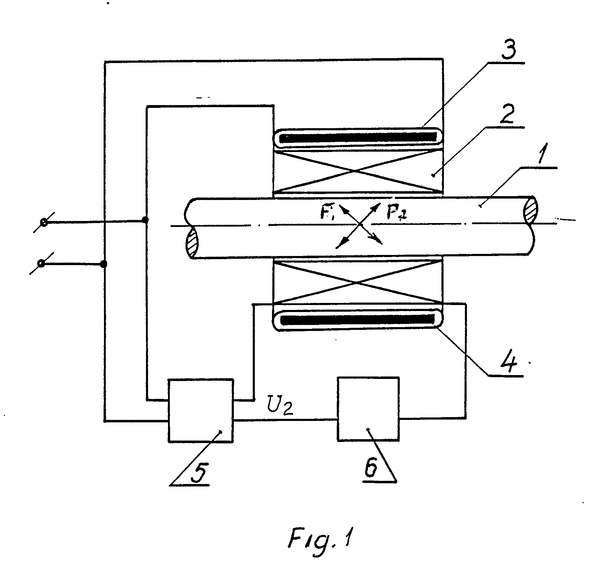

Fig. 1 zeigt einen striktiomagnetischen Wandler vom Drossel-Differentialtyp mit alternativer Funktion, dessen Welle 1 aus ferromagnetischem Werkstoff mit guten striktiomagnetischen Eigenschaften besteht. Eine Erregerwicklung 2 ist koaxial zur Welle 1 angeordnet und von einer rechtwinklig zu ihr angeordneten zweiten Erregerwicklung 3 umgeben. Die zweite Erregerwicklung 3 ist auf einen hohlen zylindrischen Magnetkern 4 gewickelt, der die Welle 1 und die Erregerwicklung 2 koaxial umgibt. Die Erregerwicklung 3 ist an eine Wechselspannungsquelle angeschlossen. Die Wicklung 2 ist mit einem Kommutator 5 verbunden, der die Spannungsphase alternativ ändert oder umschaltet, und mit einem Umformer 6 zur Aufnahme des Ausgangssignals in Reihe geschaltet.

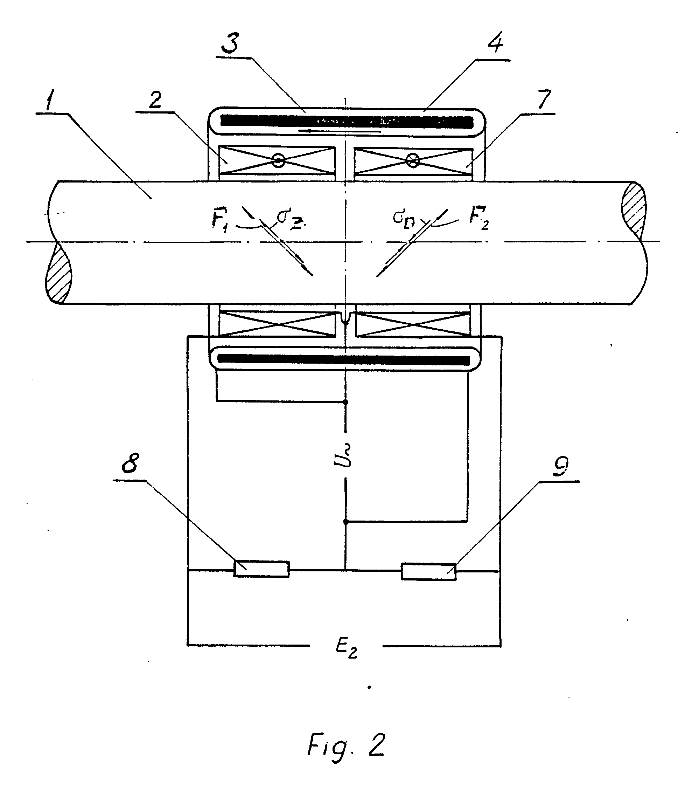

Der Wandler der Fig. 2 besteht aus einer Welle 1 aus ferromagnetischem Werkstoff, Erregerwicklungen 2 und 7 mit gleicher Windungszahl, die nebeneinander und koaxial zur Welle 1 angeordnet sind, und einer Erregerwicklung 3, die rechtwinklig zu den beiden ersten Erregerwicklungen 2 und 7 angeordnet und auf einen torusförmigen Magnetkern 4 gewickelt ist. Der Magnetkern 4 ist koaxial zur Welle 1 angeordnet und umgibt die Wicklungen 2 und 7, die gegeneinander geschaltet und mittels Widerständen 8 und 9 in eine mit Wechselspannung gespeiste Brückenschaltung geschaltet sind. Die Wicklung 3 wird mit der gleichen Spannung gespeist. Die Windungszahl der Wicklungen 2 und 7 steht zur Windungszahl der Wicklung 3 in einem Verhältnis, das abhängig ist vom Widerstand der Widerstände 8, 9, was eine Gleichheit der Absolutwerte der orthogonalen Vektoren der magnetischen Induktionen gewährleistet, die von den entsprechenden Wicklungen im Bereich des Magnetkerns 4 erregt werden.

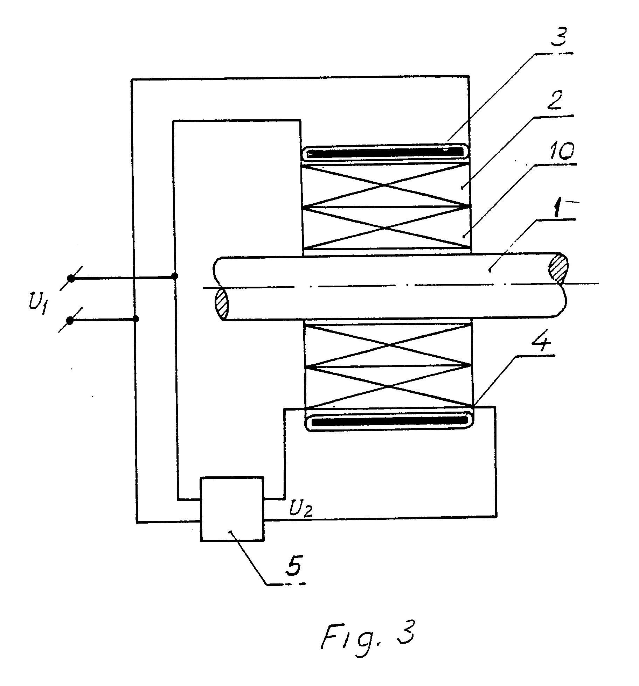

Der Wandler der Fig. 3 besteht aus einer Welle 1 aus ferro magnetischem Werkstoff, einer Erregerwicklung 2 und einer Meßwicklung 10, die die Welle 1 koaxial umgeben und übereinander angeordnet sind. Eine Erregerwicklung 3 ist rechtwinklig zu den anderen Wicklungen auf einen zylindrischen Magnetkern 4 gewickelt, der die Welle und die Wicklungen 2 und 10 koaxial umgibt. Die Erregerwicklung 3 ist mit einer Wechselspannungsquelle, die Erregerwicklung 2 mit einem Kommutator 5 verbunden, der die Spannungsphase umschaltet.

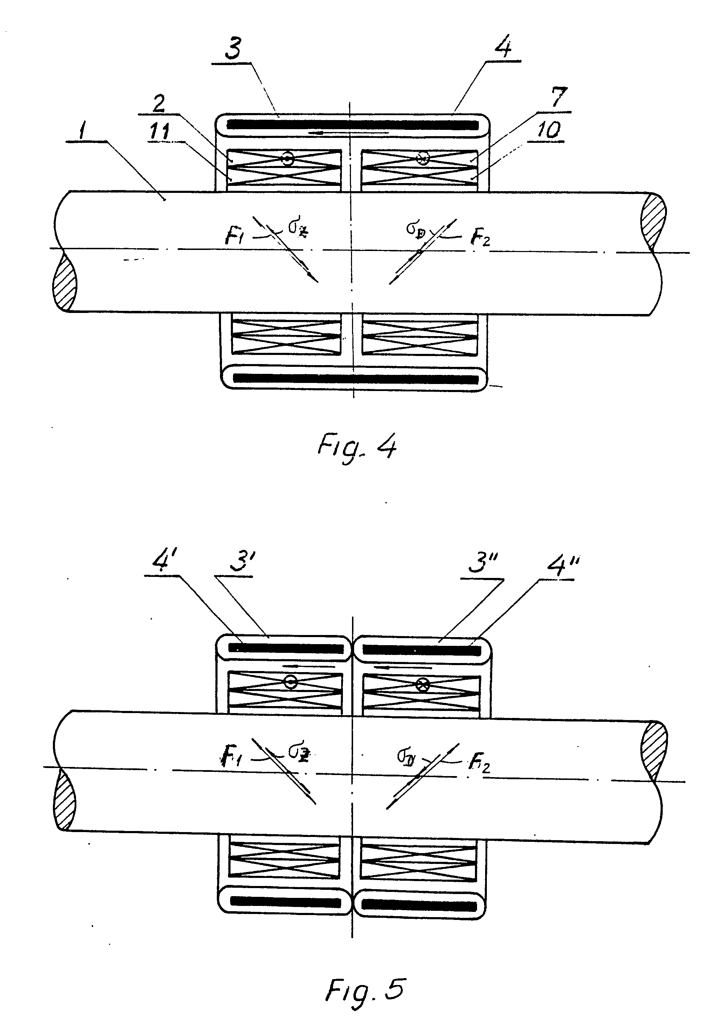

Der Wandler der Fig. 4 enthält außer der Welle 1 aus ferromagnetischem Werkstoff und einer Erregerwicklung 2 eine Erregerwicklung 7, deren Windungszahl gleich der der Erregerwicklung 2 ist. Die Erregerwicklungen 2 und 7 sind nebeneinander koaxial zur Welle 1 angeordnet. Eine Erregerwicklung 3 ist rechtwinklig zu den beiden Wicklungen 2 und 7 auf einen torusförmigen Magnetkern 4 gewickelt, der die beiden ersten Wicklungen 2 und 7 von außen umschließt und koaxial zu diesen angeordnet ist. Die beiden ersten Wicklungen 2 und 7 sind gegeneinander geschaltet und in Reihe oder parallel zur Wicklung 3 an eine Wechselspannungsquelle angeschlossen. Der Wandler der Fig. 4 enthält weiter Meßwicklungen 10 und 11 mit gleicher Windungszahl, die koaxial zur Welle 1 und unterhalb den Wicklungen 2 und 7 angeordnet und in eine Transformator-Differentialschaltung geschaltet sind.

Der Wandler der Fig. 5 unterscheidet sich von dem der Fig. 4 dadurch, daß die Wicklung 3 und der Magnetkern 4 zentral und quer in zwei identische, autonome Magnetsysteme getrennt sind, die aus den Wicklungen $3'$ und $3''$ und den Magnetkernen $4'$ und $4''$ bestehen, die oberhalb der Wicklungen 2 bzw. 7 angeordnet sind.

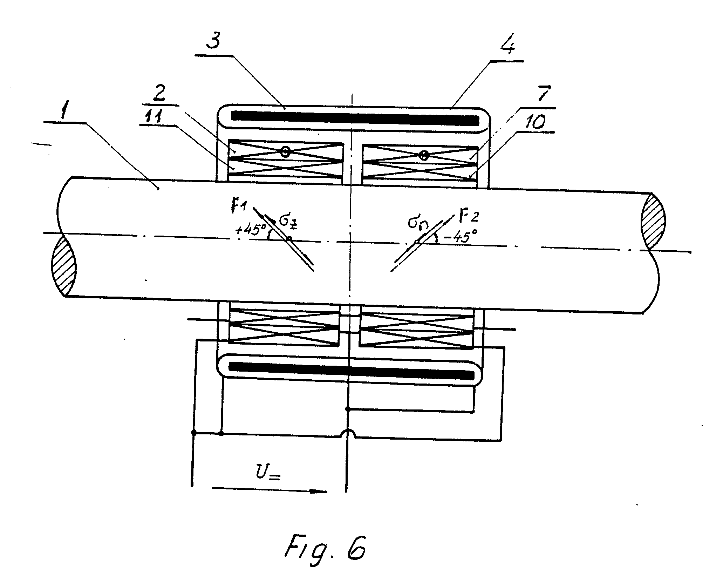

Der in Fig. 6 gezeigte Wandler vom Transformator-Differen tialtyp enthält eine Welle 1 aus ferromagnetischem Werkstoff, Erregerwicklungen 2 und 7 mit gleicher Windungszahl, die nebeneinander und koaxial zur Welle 1 angeordnet sind, Meßwicklungen 10 und 11 mit gleicher Windungszahl, die unterhalb der Wicklungen 2 bzw. 7 angeordnet sind, und eine rechtwinklig zu den Wicklungen 2 und 7 auf einen torusförmigen Magnetkern 4 gewickelte Wicklung 3. Der Magnetkern 4 ist koaxial zur Welle 1 angeordnet und umgibt die übrigen Wicklungen 2 und 7. Die Erregerwicklungen 2 und 7 sind gegeneinander geschaltet und zusammen mit der Wicklung 3 an eine Gleichspannungsquelle angeschlossen und so bemessen, daß die im Magnetkern 4 erregten, zueinander rechtwinkligen magnetischen Induktionen einander gleich sind. Die Meßwicklungen 10 und 11 sind in gleicher Richtung angeschlossen.

Zum Messen oder Erfassen differentieller Änderungen der Winkelbeschleunigung muß das eine Ende der Welle frei und ein Schwungrad an diesem befestigt sein.

Die Wandler sämtlicher Ausführungsformen können auch mit einer Welle aus nichtferromagnetischem Werkstoff ausgeführt werden, jedoch muß dann auf den aktiven Bereich der Welle 1 ein Band aufgeklebt oder mechanisch befestigt sein, das gute striktiomagnetische Eigenschaften aufweist. Auch kann dieser Bereich der Welle mit einem amorphen oder anderen Werkstoff mit guten striktiomagnetischen Eigenschaften überzogen werden.

Der erfindungsgemäße Wandler arbeitet wie folgt:

Der von der Wicklung 2 erregte Magnetfluß durchfließt die Welle 1, die Luftspalte zwischen der Welle und dem Umfang des Magnetkerns 4 und wird durch den Magnetkern 4 geschlossen. Der von der Wicklung 3 erregte Magnetfluß schließt sich vollständig durch den torusförmigen Magnetkern 4. Im Bereich des Magnetkerns 4 liegen die von den Wicklungen 2 und 3 erregten magnetischen Induktionen rechtwinklig zueinander, und beim Ausgleich ihrer Absolutwerte verläuft die resultierende magnetische Induktion bzw. der Fluß $F_1$, $F_2$ nach Helikoiden, die bezüglich der Achse in einem Winkel von ± 45° orientiert sind, und zwar in Abhängigkeit davon, ob die die Wicklungen 2 und 3 speisenden Spannungen in Phase oder Gegenphase sind. Dieses Umschalten erfolgt über bestimmte Zeitperioden durch den Kommutator 5. Das Magnetfeld verläuft im Bereich der Luftspalte radial, da die Permeabilität der Luft um mehrere Größenordnungen kleiner ist als die der Welle 1 und des Magnetkerns 4. Entsprechend dem Prinzip der Kontinuität der magnetischen Kraftlinien im Bereich der Welle 1 hat der Magnetfluß ebenfalls helikoidalen Charakter mit den gleichen Parametern der Helikoiden, jedoch mit umgekehrtem Verlauf. Beim Erzeugen eines Drehmoments entstehen in der Welle 1 mechanische Zugspannungen $\sigma_Z$ und Druckspannungen $\sigma_D$ mit entgegengesetzten Vorzeichen, die senkrecht zueinander gerichtet sind und mit der Achse einen Winkel von + 45° und - 45° einschließen. Sie sind über bestimmte Zeitperioden einzeln kolinear mit dem einen oder anderen der beiden helikoidalen Magnetflüsse. Wegen des striktiomagnetischen Effekts verursachen die mechanischen Spannungen mit entgegengesetzten Vorzeichen eine Änderung der Permeabilität mit entgegengesetzem Vorzeichen in den entsprechenden Richtungen und eine entsprechende Änderung mit entgegengesetztem Vorzeichen der Magnetflüsse, die über zwei aufeinanderfolgende Arbeitszyklen des Wandlers von den Erregerwicklungen 2 und 3 erzeugt werden. Das erhaltene, dem Drehmoment proportionale Signal wird mittels des Umformblocks 6 registriert, der mit der Erregerwicklung 3 in Reihe geschaltet ist (Fig. 1).

Bei einem Wandler vom Transformator-Differentialtyp (Fig. 3) werden bei Änderung der Magnetflüsse $F_1$ und $F_2$ mit entgegengesetztem Vorzeichen in der Meßwicklung 10 während der einzelnen Zyklen Spannungen induziert, deren Unterschied dem auf den Wandler einwirkenden Drehmoment porportional ist.

Bei den in den Fig. 2, 4 und 5 gezeigten Wandlern ohne alternative Funktion sind die Vorgänge analog; sie verlaufen aber nicht zeitlich aufeinanderfolgend, sondern sind durch Ausbildung zweier identischer Glieder der Wicklungen 2 und 7 räumlich getrennt. Die Erregerwicklungen 2 und 7 erregen die Flüsse $F_1$ und $F_2$ gleichzeitig, die ebenfalls rechtwinklig zueinander gerichtet sind, und zwar unter einem Winkel von $\pm\ 45°$ in Bezug auf die Achse der Welle 1. Die Änderung mit entgegengesetztem Vorzeichen der magnetischen Leitfähigkeiten in den einzelnen Bereichen und die entsprechende Änderung mit entgegengesetztem Vorzeichen der darin verlaufenden Magnetflüsse wird parametrisch durch eine Brückenschaltung (Fig. 2) oder transformatorisch durch eine Transformator-Differentialschaltung mit zum Drehmoment proportionalem elektrischem Signal (Fig. 4, 5) registriert. Bei Gleichstromsspeisung der Erregerwicklungen (Fig. 6) und beim Fehlen zeitlicher Änderungen der magnetischen Eigenschaften der Welle 1 wird in die differential geschalteten Meßwicklungen 10 und 11 keine elektromotorische Kraft induziert, da die Flüsse $F_1$ und $F_2$ konstant sind. Bei zeitlichen Änderungen der mechanischen Spannungen in der Welle 1 infolge vom zu messenden Drehmoment $M_d$ hervorgerufener Torsion ändern sich infolge des striktiomagnetischen Effekts mit entgegengesetztem Vorzeichen die Permeabilität in den entsprechenden Richtungen in beiden Bereichen. Dabei ändern sich auch die magnetischen Leitfähigkeiten und die Magnetflüsse, wodurch in die Meßwicklungen den Änderungen proportionale elektrische Signale induziert werden. Durch gleichsinnige Verbindung der Meßwicklungen 10 und 11 werden diese Signale summiert, wodurch die Empfindlichkeit praktisch verdoppelt wird. Zu einer hohen Empfindlichkeit trägt jedoch in höchstem Maße die Tatsache bei, daß ein magnetomechanisches System realisiert wird, bei dem die Richtung der Flüsse mit der Richtung der mechanischen Spannungen im gesamten Umformbereich der Welle zusammenfällt.

Das erhaltene elektrische Signal $E_M$ ist proportional zu den differentialen Änderungen des Drehmoments $M_d$. Der Proportionalitätsfaktor $K_M$ ist abhängig von der Permeabilität der Welle 1 und des Werkstoffs, von der Sättigungs-Magnetostriktion und der Sättigungsinduktion der Welle 1, von der Anzahl der Wicklungen und Windungen und von den konstruktionstechnischen Parametern des Wandlers. Es gilt folgende Gleichung:

$$E_M = K_M \frac{d m_d}{d t}.$$

Beim Messen differentialer Änderungen der Winkelbeschleunigung ist die Wirkungsweise des Wandlers wie folgt:

Von der Dynamik der Drehbewegungen ist folgende Beziehung bekannt:

$$M_d = J \cdot \epsilon,$$

worin J das Trägheitsmoment der Welle 1 und des Schwungrades und $\epsilon$ die Winkelbeschleunigung ist. Nach Differenzieren dieser Gleichung erhält man:

$$\frac{d m_d}{d t} = J \frac{d\epsilon}{dt}.$$

Dieser Ausdruck wird in den Ausdruck für $E_M$ substituiert, mit dem Ergebnis:

$$E_\epsilon = K_M \cdot J \frac{d\epsilon}{dt} = K_\epsilon \frac{d\epsilon}{dt}$$

worin $K_\epsilon$ von $K_M$ und zusätzlich vom Trägheitsmoment des Schwungrades und der Welle abhängig ist.

Das elektrische Ausgangssignal $E_\epsilon$ des Wandlers ist bei an einem Ende der Welle 1 befestigtem Schwungrad proportional der differentialen Änderung der Winkelbeschleunigung bei umlaufender Welle.

## Ansprüche

Striktiomagnetischer Wandler zum Erfassen und Messen von Drehmomenten und ihrer dynamischen Änderungen, mit einer Welle (1), die wenigstens an ihrer Oberfläche einen ferromagnetischen Werkstoff mit striktiomagnetischen Eigenschaften aufweist, und mit wenigstens zwei konzentrisch zur Welle (1) angeordneten Wicklungen (2, 7), dadurch **gekennzeichnet**, daß die äußerste der Wicklungen eine Erregerwicklung (3) und in Bezug auf die anderen Wicklungen rechtwinklig auf einen hohlen zylindrischen Magnetkern (4) gewickelt ist, der die Welle (1) und übrigen Wicklungen (2, 7, 10, 11) koaxial umgibt.

87720

38954.8

$F_1$   $P_1$

$U_2$

Fig. 1

Fig. 2

38954.8

87720

Fig. 3

Fig. 4

Fig. 5

38954.8

87720

Fig. 6